# EUROPEAN PATENT APPLICATION

(11) **EP 4 787 630 A1**
(43) Date of publication of application: **05.08.2026**
(21) Application number: 26155940.5
(22) Date of filing: 03.02.2026
(51) Int. Cl.: H01R 13/405, H01R 43/24, B29C 45/16, G01R 33/00

(54) **WIRING UNIT, MAGNETIC SENSOR UNIT, AND METHOD OF MANUFACTURING WIRING UNIT**

(30) Priority: 04.02.2025 JP 2025017147
(71) Applicant: TDK Corporation, Tokyo 103-6128 (JP)
(72) Inventor: ISHIKAWARA, Toshio, Tokyo, 103-6128 (JP); NAKAZAWA, Shinichi, Tokyo, 103-6128 (JP); OYAMA, Toshihiko, Tokyo, 103-6128 (JP)
(74) Representative: Epping - Hermann - Fischer

(57) **Abstract**

A wiring unit in which a plurality of terminals including at least a first terminal and a second terminal are resin-molded, wherein the first terminal has a first extended portion extending in a first direction and being provided with a first notch portion, the second terminal has a second extended portion extending in the first direction and being provided with a second notch portion, and at least a part of the first extended portion and at least a part of the second extended portion face each other while being spaced apart in a second direction perpendicular to the first direction, and when the first notch portion and the second notch portion are viewed in a plan view along the second direction from a side opposite to the side where at least a part of the first extended portion faces at least a part of the second extended portion, the first notch portion encompasses the second notch portion.

## Description

### CROSS REFERENCE TO RELATED APPLICATION

This application claims the benefit of Japanese Priority Patent Application No. 2025-017147 filed on February 4, 2025, the entire contents of which are incorporated herein by reference.

### FIELD

The present disclosure relates to a wiring unit, a magnetic sensor unit, and a method of manufacturing a wiring unit.

### BACKGROUND

In various electronic devices, wiring units with metal terminals embedded with resin molds are used by being connected to substrates mounted with sensors and the like. Such wiring units are formed by injecting molten resin into a mold while the metal terminals are temporarily fixed to the mold, followed by cooling. In wiring units with complex internal structures, techniques such as layering terminals by combining primary molding and secondary molding are observed (for example, refer to Patent Publication JP-A-2012-164447).

### SUMMARY

When manufacturing a wiring unit in which terminals being metal pieces are stacked and arrayed, conventional methods of forming resin molds for each layer and stacking the resin molds involve a complex manufacturing process, sometimes resulting in increased costs and lead times. On the other hand, attempting to form the wiring unit in a single molding process often results in displacement of positions of terminals arranged within slide molds or deformation of the terminals due to inflow pressure of resin and arrangement adjustments of the molds, making it difficult to precisely array the stacked terminals.

A wiring unit according to a first aspect of the present disclosure is a wiring unit in which a plurality of terminals including at least a first terminal and a second terminal are resin-molded, wherein the first terminal has a first extended portion extending in a first direction and being provided with a first notch portion, the second terminal has a second extended portion extending in the first direction and being provided with a second notch portion, and at least a part of the first extended portion and at least a part of the second extended portion face each other while being spaced apart in a second direction perpendicular to the first direction, and when the first notch portion and the second notch portion are viewed in a plan view along the second direction from a side opposite to the side where at least a part of the first extended portion faces at least a part of the second extended portion, the first notch portion encompasses the second notch portion.

A magnetic sensor unit according to a second aspect of the present disclosure includes: the wiring unit described above; and a sensor substrate being connected to the first terminal and the second terminal and mounted with a magnetic sensor chip.

A method of manufacturing a wiring unit according to a third aspect of the present disclosure is a method of manufacturing a wiring unit in which a plurality of terminals including at least a first terminal and a second terminal are resin-molded, the method of manufacturing the wiring unit including the steps of: locking a first notch portion provided in a first extended portion extending in a first direction in the first terminal to a first locking portion of a protrusion provided in a first mold and fixing the first notch portion to the first mold; locking a second notch portion provided in a second extended portion extending in the first direction in the second terminal to a second locking portion provided on a side of an end portion of the protrusion relative to the first locking portion in the protrusion and fixing the second notch portion to the first mold such that at least a part of the first extended portion and at least a part of the second extended portion face each other while being spaced apart in a second direction perpendicular to the first direction; and filling resin into an internal space formed by the first mold and other molds including a second mold.

### BRIEF DESCRIPTION OF THE DRAWINGS

The accompanying drawings are included to provide a further understanding of the disclosure and are incorporated in and constitute a part of this specification. The drawings illustrate example embodiments and, together with the specification, serve to explain the principles of the technology.
FIG. 1 is a perspective view of an upper surface side of a wiring unit according to the present example embodiment;
FIG. 2 is a perspective view of a bottom surface side of the wiring unit according to the present example embodiment;
FIG. 3 is a perspective view of a side surface side of the wiring unit according to the present example embodiment;
FIG. 4 is a perspective view of an arrangement of a first terminal and a second terminal in a state of being fixed to the wiring unit;
FIG. 5 is a perspective view showing the first terminal and the second terminal being fixed to a first mold;
FIG. 6 is a perspective view of a partial cross section of the first mold cut along a plane P shown in FIG. 5;
FIG. 7 is a top view showing first to fifth terminals being fixed to the first mold;
FIGS. 8A and 8B are explanatory diagrams of a shape of a first extended portion and a shape of a second extended portion;
FIG. 9 is a bottom view of the wiring unit; and
FIG. 10 is a perspective view of a magnetic sensor unit in which a sensor substrate is mounted to the wiring unit.

### DETAILED DESCRIPTION

The present disclosure provides a wiring unit and the like in which at least two stacked resin-molded terminals are precisely arrayed without coming into contact with each other.

In the following, some example embodiments and modification examples of the technology are described in detail with reference to the accompanying drawings. Note that the following description is directed to illustrative examples of the disclosure and not to be construed as limiting the technology. Factors including, without limitation, numerical values, shapes, materials, components, positions of the components, and how the components are coupled to each other are illustrative only and not to be construed as limiting the technology. Further, elements in the following example embodiments which are not recited in a most-generic independent claim of the disclosure are optional and may be provided on an as-needed basis. The drawings are schematic and are not intended to be drawn to scale. Like elements are denoted with the same reference numerals to avoid redundant descriptions.

Hereinafter, one example embodiment of the present disclosure will be described with reference to the drawings. Note that components designated by same reference signs in the respective drawings represent the same or similar components. In addition, when structures sharing the same or a similar configuration exist in plurality in each drawing, some structures may be accompanied with signs while others may not in order to avoid complication. Note that the description of the one example embodiment of the present disclosure is not intended to limit the technology related to the scope of claims to the example embodiment described below. In addition, not all of the components described in the example embodiment are essential as means for solving the problem.

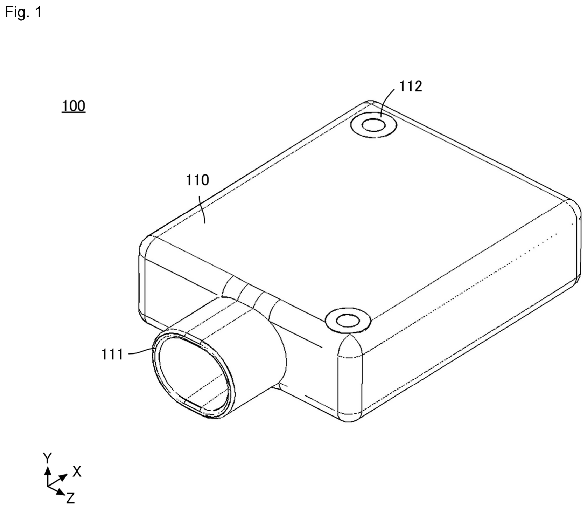

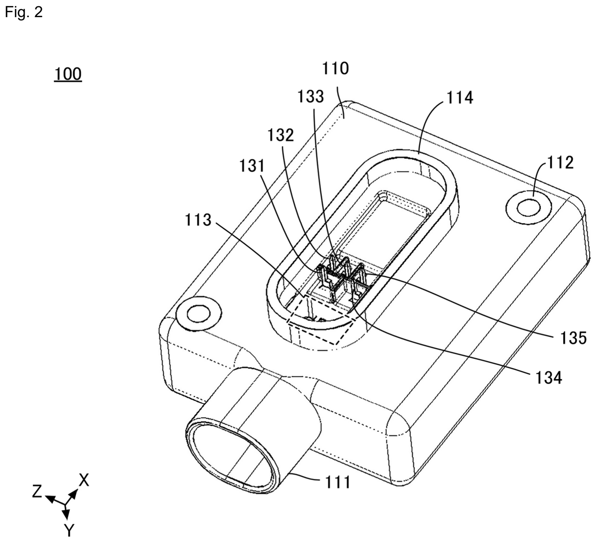

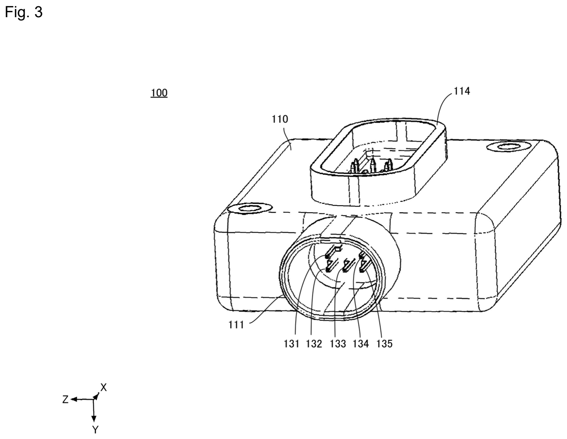

FIG. 1 is a perspective view of an upper surface side of a wiring unit 100 according to the present example embodiment. FIG. 2 is a perspective view of a bottom surface side of the wiring unit 100 according to the present example embodiment. FIG. 3 is a perspective view of a side surface side of the wiring unit 100 according to the present example embodiment.

Note that in the description of the present example embodiment, a three-dimensional space defined by three directions -a first direction, a second direction, and a third direction- is used. For example, the first direction is an X-axis direction, the second direction is a Y-axis direction, and a third direction is a Z-axis direction. Furthermore, in the present example embodiment, as illustrated in FIG. 1, a surface on a side of the positive Y-axis direction of the wiring unit 100 is defined as a top surface, with a center of the wiring unit 100 serving as a reference. In other words, a direction toward the top surface side of the wiring unit 100 is defined as the positive Y-axis direction, with the center of the wiring unit 100 serving as the reference. In addition, a surface on a side of the negative Y-axis direction of the wiring unit 100 is defined as a bottom surface, with the center of the wiring unit 100 serving as a reference. In other words, a direction toward the bottom surface side of the wiring unit 100 is defined as the negative Y-axis direction, with the center of the wiring unit 100 serving as the reference. Furthermore, a direction perpendicular to the Y-axis and oriented toward an opening of an insertion port 111, with the center of the wiring unit 100 serving as the reference, is defined as the negative X-axis direction. In addition, a direction opposite to the direction toward the opening of the insertion port 111, with the center of the wiring unit 100 serving as the reference, is defined as the positive X-axis direction. The Z-axis is perpendicular to the X-axis and the Y-axis, and orientations of positive and negative are defined according to a right-handed coordinate system. In subsequent drawings, similar coordinate axes with respect to the state where the wiring unit 100 is arranged as shown in FIGS. 1 to 3 are shown together to indicate an orientation of a structure represented by each drawing. Note that as described above, a predetermined position in the positive Y-axis direction may be referred to as "up" while a predetermined position in the negative Y-axis direction may be referred to as "down" or "bottom".

In addition, while the first direction, the second direction, and the third direction correspond to the X-axis direction, the Y-axis direction, and the Z-axis direction, respectively, in the present example embodiment, the first direction, the second direction, and the third direction are not limited thereto and may correspond to other directions, respectively.

In the wiring unit 100 according to the present example embodiment, five metal terminals (first terminal 131, second terminal 132, third terminal 133, fourth terminal 134, and fifth terminal 135) may be resin-molded. The molded resin may form an outer shell as an integral resin block 110. The resin block 110 may have the insertion port 111 for receiving a connector to be connected, a fixing portion 112 with a hole for fixing the wiring unit 100 to another structure, a recessed portion 113 capable of exposing a part of each terminal to an external space, and a substrate housing wall 114 surrounding a space for accommodating a sensor substrate 210 to be described later.

As shown in FIG. 3, the insertion port 111 may be provided in a cylindrical shape so as to surround an end portion on one end side of each terminal extending in the negative X-axis direction. In the present example embodiment, the insertion port 111 may be formed using a slide-type mold that is inserted and withdrawn laterally relative to a fixed mold and a movable mold enclosing the resin block 110 so that an end portion of each terminal protrudes into an external space.

Two fixing portions 112 are provided on a diagonal of the resin block 110 on an X-Z plane. Each of the two fixing portions 112 has a hole, and a cylindrical bush is fitted into each hole. When fixing the wiring unit 100 to another structure, the wiring unit 100 is fixed by inserting a fixing bolt or the like into the bush.

As shown in FIG. 2, the recessed portion 113 may be a depression provided so as to have an opening on a bottom surface side, and while details will be provided later, a part of each of the plurality of terminals can be observed via the recessed portion 113. Although details will be provided later, each of the terminals has an L-shape bent between one end and another end, and as shown in FIG. 3, the one end of each terminal is exposed in a space enclosed by the insertion port 111 while the other end is exposed in the space enclosed by the substrate housing wall 114. More specifically, the first terminal 131 and the second terminal 132 are arranged parallel to each other and the fourth terminal 134 and the fifth terminal 135 are similarly arranged parallel to each other. The third terminal 133 is arranged between the second terminal 132 and the fifth terminal 135.

As shown in FIGS. 2 and 3, the substrate housing wall 114 may be erected in a rounded rectangular shape on the bottom surface side, and the opening of the recessed portion 113 and the other end of each terminal exposed to the outside are positioned on an inner peripheral side of the substrate housing wall 114 with the rounded rectangular shape. Although details will be provided later, the sensor substrate 210 is housed in the space enclosed by the substrate housing wall 114 and fixed to the resin block 110. In this case, the other end of each terminal is connected to the wiring of the sensor substrate 210 to ensure electrical continuity.

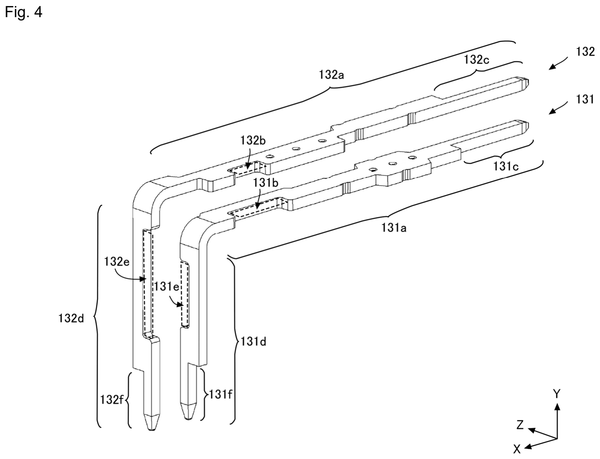

FIG. 4 is a perspective view of an arrangement of the first terminal 131 and the second terminal 132 in a state of being fixed to the wiring unit 100. As shown in FIG. 4, the first terminal 131 with an L-shape and the second terminal 132 with an L-shape but longer in overall length than the first terminal 131 are arranged parallel and spaced apart along a predetermined direction.

The first terminal 131 is formed by, for example, punching a metal sheet and subsequently bending the metal sheet. The first terminal 131 has a first extended portion 131a provided with a first notch portion 131b to be described later and extending in the X-axis direction. The first extended portion 131a corresponds to one of the two straight line portions that form the L-shape. The first extended portion 131a has the first notch portion 131b formed in a concave shape in a side portion along the X-axis direction. In other words, the first notch portion 131b is a concave shape formed in the Z-axis direction in a part of the first extended portion 131a.

In addition, the first extended portion 131a may have, on the side of the one end in the X-axis direction, a first end portion 131c formed with a reduced width being a length in the Z-axis direction and capable of being connected to other wiring. The first end portion 131c is exposed to the space enclosed by the insertion port 111 as described with reference to FIG. 3.

The first terminal 131 may have a third extended portion 131d extending in the Y-axis direction. The third extended portion 131d corresponds to the other of the two straight line portions that form the L-shape together with the first extended portion 131a. In other words, the third extended portion 131d is connected to another end of the first extended portion 131a which is opposite to the one end where the first end portion 131c is provided. While the third extended portion 131d extends in the Y-axis direction that is perpendicular to the first extended portion 131a in the present example embodiment, the direction in which the third extended portion 131d extends may be another direction (fourth direction) that intersects with the X-axis direction.

The third extended portion 131d may have a third notch portion 131e formed in a concave shape in a side portion along the Y-axis direction. In other words, the third notch portion 131e is a concave shape formed in the Z-axis direction in a part of the third extended portion 131d. In addition, the third extended portion 131d has, on the side of the one end in the Y-axis direction, a third end portion 131f formed with a reduced width being a length in the Z-axis direction and capable of being connected to other wiring. The third end portion 131f is exposed to the space enclosed by the substrate housing wall 114 as described with reference to FIGS. 2 and 3. For example, the third end portion 131f is soldered to the wiring of the sensor substrate 210 to be described later. Due to the formation of the third notch portion 131e in the third extended portion 131d, heat transfer to the side of the first extended portion 131a can be suppressed when the third end portion 131f is soldered to the wiring of the sensor substrate 210. Accordingly, damage to the resin block 110 caused by deformation of the first terminal 131 can be suppressed.

The second terminal 132 may be formed by, for example, punching a metal sheet and subsequently bending the metal sheet in a similar manner to the first terminal 131. The second terminal 132 has a second extended portion 132a provided with a second notch portion 132b to be described later and extending in the X-axis direction. The second extended portion 132a is a portion extending in the first direction from the bend position of the first terminal 131 having an L-shape. The second extended portion 132a has the second notch portion 132b formed in a concave shape in a side portion along the X-axis direction. In other words, the second notch portion 132b is a concave shape formed in the Z-axis direction in a part of the second extended portion 132a.

In addition, the second extended portion 132a has, on the side of the one end in the X-axis direction, a second end portion 132c formed with a reduced width being a length in the Z-axis direction and capable of being connected to other wiring. The second end portion 132c is exposed to the space enclosed by the insertion port 111 as described with reference to FIG. 3.

The second terminal 132 may have a fourth extended portion 132d extending in the Y-axis direction. The fourth extended portion 132d corresponds to the other of the two straight line portions that form the L-shape together with the second extended portion 132a. In other words, the fourth extended portion 132d is connected to another end of the second extended portion 132a which is opposite to the one end where the second end portion 132c is provided. While the fourth extended portion 132d extends in the Y-axis direction that is perpendicular to the second extended portion 132a in the present example embodiment, the direction in which the fourth extended portion 132d extends may be a direction that is parallel to the third extended portion 131d.

The fourth extended portion 132d may have a fourth notch portion 132e formed in a concave shape in a side portion along the Y-axis direction. In other words, the fourth notch portion 132e is a concave shape formed in the Z-axis direction in a part of the fourth extended portion 132d. In addition, the fourth extended portion 132d has, on the side of the one end in the Y-axis direction, a fourth end portion 132f formed with a reduced width being a length in the Z-axis direction and capable of being connected to other wiring. The fourth end portion 132f is exposed to the space enclosed by the substrate housing wall 114 as described with reference to FIGS. 2 and 3. For example, the fourth end portion 132f is soldered to the wiring of the sensor substrate 210. Due to the formation of the fourth notch portion 132e in the fourth extended portion 132d, heat transfer to the side of the second extended portion 132a can be suppressed when the fourth end portion 132f is soldered to the wiring of the sensor substrate 210. Accordingly, damage to the resin block 110 caused by deformation of the second terminal 132 can be suppressed.

At least a part of the first extended portion 131a and at least a part of the second extended portion 132a may be arranged so as to face each other while being spaced apart in the Y-axis direction. In the present example embodiment, the second extended portion 132a positioned on a top surface side is longer in the X-axis direction than the first extended portion 131a positioned on a bottom surface side, and a tip of the first end portion 131c and a tip of the second end portion 132c are at the same position in the X-axis direction. In addition, a part of the second extended portion 132a and all of the first extended portion 131a are arranged in parallel.

At least a part of the third extended portion 131d and at least a part of the fourth extended portion 132d may be arranged so as to face each other while being spaced apart in the X-axis direction. In the present example embodiment, a total length of the fourth extended portion 132d is longer than a total length of the third extended portion 131d, and a tip of the third end portion 131f and a tip of the fourth end portion 132f are at the same position in the Y-axis direction.

The first notch portion 131b and the second notch portion 132b each have a concave shape, or in other words, a rectangular shape. A length of the first notch portion 131b along the X-axis direction is longer than a length of the second notch portion 132b along the X-axis direction. In addition, the length of the first notch portion 131b along the Z-axis direction is the same as the length of the second notch portion 132b along the Z-axis direction. Specifically, in a plan view of the first notch portion 131b and the second notch portion 132b along the Y-axis direction from the side of the first terminal 131, the first notch portion 131b encompasses the second notch portion 132b. In other words, when observed along the Y-axis direction from the side of the first terminal 131, a contour of the second notch portion 132b can be observed.

The third end portion 131f and the fourth end portion 132f at least partially overlap with each other when viewed in a plan view along the X-axis direction. For example, the third end portion 131f and the fourth end portion 132f may be aligned on lattice points together with an array of respective end portions of the third terminal 133, the fourth terminal 134, and the fifth terminal 135.

While shapes of the first terminal 131 and the second terminal 132 have been described above, the third terminal 133, the fourth terminal 134, and the fifth terminal 135 may have the same shape as either the first terminal 131 or the second terminal 132. In addition, while a relative arrangement relationship between the first terminal 131 and the second terminal 132 has been described above, when the shape of the fourth terminal 134 is the same as the shape of the first terminal 131 and the shape of the fifth terminal 135 is the same as the shape of the second terminal 132, the relative arrangement relationship between the fourth terminal 134 and the fifth terminal 135 is the same as the relative arrangement relationship between the first terminal 131 and the second terminal 132.

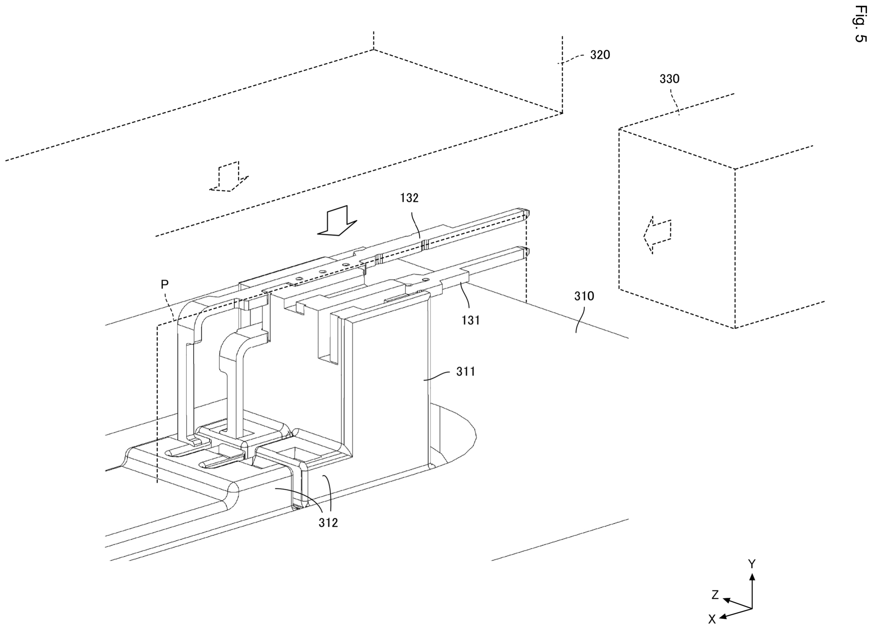

FIG. 5 is a perspective view showing the first terminal 131 and the second terminal 132 being fixed to a first mold 310 that is a bottom mold. The first mold 310 has a protrusion 311 for fixing the first terminal 131 and the second terminal 132 to a predetermined position, and an insertion portion 312 into which end portions (for example, the third end portion 131f and the fourth end portion 132f) that protrude into the space enclosed by the substrate housing wall 114 are to be inserted.

As illustrated, the protrusion 311 may protrude in the positive Y-axis direction in the first mold 310. Regarding the first terminal 131 and the second terminal 132 in which the first extended portion 131a and the second extended portion 132a are arranged spaced apart from each other in the Y-axis direction, the first terminal 131 to be arranged on the bottom surface side is placed at a predetermined position of the protrusion 311 in the negative Y-axis direction as indicated by a solid arrow in FIG. 5. Next, the second terminal 132 to be arranged on the top surface side is placed at a predetermined position of the first mold 310. Next, the third terminal 133 is placed at a predetermined position of the first mold 310 of which a position in the Z-axis direction differs from that of the first terminal 131. Next, the fourth terminal 134 to be arranged on the bottom surface side is placed at a predetermined position of the first mold 310 of which a position in the Z-axis direction differs from that of the first terminal 131. Next, the fifth terminal 135 to be arranged on the top surface side is placed at a predetermined position of the first mold 310 of which a position in the Z-axis direction differs from that of the second terminal 132. Note that an operation of placing each terminal in the protrusion 311 is executed by an operator, a robot hand, or the like. In addition, an order in which each terminal is placed onto the first mold 310 is not limited to this example, with the exception of placing the first terminal 131 onto the first mold 310 before the second terminal 132 and placing the fourth terminal 134 onto the first mold 310 before the fifth terminal 135.

After placing each terminal onto the first mold 310, a second mold 320 being an upper mold is placed over the first mold 310 and, furthermore, a third mold 330 being a slide mold for forming the insertion port 111 is assembled. Note that in FIG, 5, the second mold 320 and the third mold 330 are shown schematically with dotted lines, and respective assembly directions thereof are depicted by dotted arrows. Subsequently, molten resin is injected and filled into an internal cavity formed by the molds, and after the resin cools, the molds are removed to form the wiring unit 100.

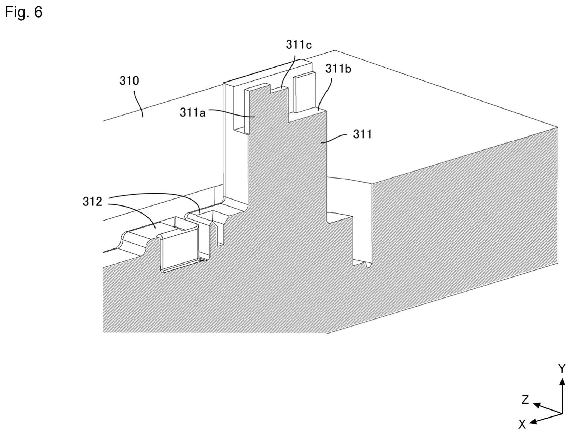

FIG. 6 is a perspective view of a partial cross section of the first mold 310 cut along a plane P shown in FIG. 5. The protrusion 311 has a columnar locking pillar portion 311a erected in the positive Y-axis direction, a first locking surface 311b that comes into contact with a part of the bottom surface of the first extended portion 131a in the first terminal 131, and a second locking surface 311c that comes into contact with a part of the bottom surface of the second extended portion 132a in the second terminal 132.

The locking pillar portion 311a and the first locking surface 311b function as a first locking portion for locking the first notch portion 131b of the first extended portion 131a. In other words, when the first terminal 131 is placed on the protrusion 311, a part of the bottom surface of the first extended portion 131a is placed along the first locking surface 311b and the first notch portion 131b is locked by the locking pillar portion 311a. Accordingly, the first terminal 131 is fixed at a predetermined position. In addition, the first notch portion 131b is locked by the locking pillar portion 311a. Therefore, when the first terminal 131 is subjected to an external force along the X-axis direction, the first terminal 131 can be prevented from deviating from the predetermined position or deforming.

In addition, the locking pillar portion 311a and the second locking surface 311c function as a second locking portion for locking the second notch portion 132b of the second extended portion 132a. In other words, when the second terminal 132 is placed on the protrusion 311, a part of the bottom surface of the second extended portion 132a is placed along the second locking surface 311c and the second notch portion 132b is locked by the locking pillar portion 311a. Accordingly, the second terminal 132 is fixed at a predetermined position. In addition, the second notch portion 132b is locked by the locking pillar portion 311a. Therefore, when the second terminal 132 is subjected to an external force along the X-axis direction, the second terminal 132 can be prevented from deviating from the predetermined position or deforming.

Specifically, even when the third mold 330 that is the slide mold shown in FIG. 5 comes into contact with the tip of the first end portion 131c or the tip of the second end portion 132c during arrangement adjustment for mold assembly, displacement of the arrangement of the first terminal 131 and the second terminal 132 and deformation of the L-shapes can be suppressed. In addition, the planes constituting the first extended portion 131a, the second extended portion 132a, the third extended portion 131d, and the fourth extended portion 132d are susceptible to inflow pressure of resin that is pressed in during filling of the resin. According to the present example embodiment, even when each plane is subjected to such inflow pressure, displacement of the arrangement of the first terminal 131 and the second terminal 132 and deformation of the L-shapes can be suppressed.

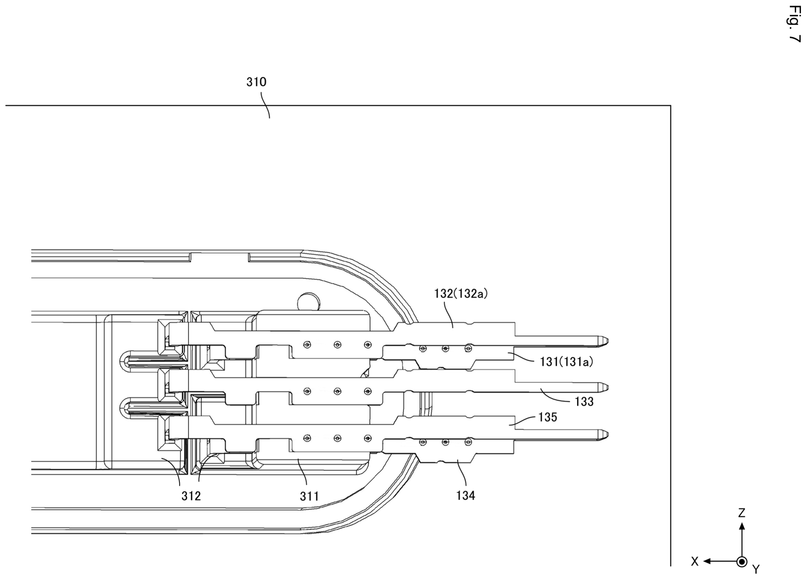

FIG. 7 is a top view showing the first terminal 131 to the fifth terminal 135 being fixed to the first mold 310. As shown in FIG. 7, when placing the first terminal 131 to the fifth terminal 135 in a mold, the first terminal 131 is positioned on the bottom surface side relative to the second terminal 132 and the fourth terminal 134 is positioned on the bottom surface side relative to the fifth terminal 135.

In the present example embodiment, the first extended portion 131a of the first terminal 131 has a first non-coinciding portion that is not hidden by the second extended portion 132a of the second terminal 132 when viewed in a plan view from the side of the top surface along the Y-axis. In other words, a contour of the first extended portion 131a and a contour of the second extended portion 132a differ from each other in a plan view along the Y-axis direction. A similar description applies to the fourth terminal 134 and the fifth terminal 135. In this manner, the first terminal 131 and the second terminal 132 are spaced apart in the Y-axis direction, and respective extended portions thereof that are arranged parallel to the X-axis direction have mutually different contours. Accordingly, by observing the first terminal 131 and the second terminal 132 from the top surface side, the operator or an image recognition processing apparatus attached to the robot hand can confirm that the first terminal 131 and the second terminal 132 are each fixed to the predetermined position of the first mold 310 in a correct order.

In addition, the third extended portion 131d of the first terminal 131 may be configured to have a second non-coinciding portion that is not hidden by the fourth extended portion 132d of the second terminal 132 when observed from the positive X-axis direction side relative to the third extended portion 131d. In other words, a configuration may be adopted in which a contour of the third extended portion 131d and a contour of the fourth extended portion 132d differ from each other in a plan view along the X-axis. A similar description applies to the fourth terminal 134 and the fifth terminal 135. By adopting such a configuration, it is possible to confirm that each terminal is fixed to the first mold 310 by observing from the positive X-axis side.

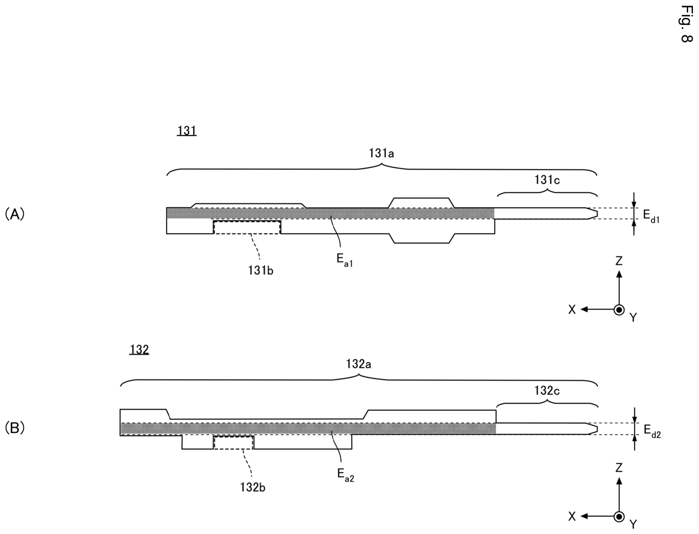

FIGS. 8A and 8B are explanatory diagrams of a shape of the first extended portion 131a and a shape of the second extended portion 132a.

FIG. 8A is a schematic view showing a contour of the first extended portion 131a. FIG. 8B is a schematic view showing a contour of the second extended portion 132a.

As shown in FIG. 8A, the first extended portion 131a has the first end portion 131c formed with a width (E_{d1}) being a length in the Z-axis direction that is narrower than widths of other portions. In FIG. 8A, when an area extending the width of the first end portion 131c in the positive X-axis direction (indicated by hatchings) is defined as a first area Eₐ₁, the first notch portion 131b does not overlap with the first area Eₐ₁. In other words, in a plan view along the Y-axis direction, the first area Eₐ₁ based on a length E_{d1} of the first end portion 131c along the Z-axis direction and the first notch portion 131b do not overlap with each other. For example, in a plan view along the Y-axis direction, the first area Eₐ₁ is an area defined by the length E_{d1} being a length of one side of the first area Eₐ₁, two line segments perpendicular along the X-axis direction to each of both ends of the one side with the length E_{d1}, and a side parallel to the length E_{d1}. Since the first extended portion 131a can achieve certain rigidity due to having this shape, deformation such as bending when the first end portion 131c is subjected to an external force in the positive X-axis direction can be suppressed. Note that a length of the first end portion 131c along the Z-axis direction may be longer than a length of the first notch portion 131b along the Z-axis direction. While an example in which the shape of the first area Eₐ₁ is a rectangular shape is described in the present example embodiment, the shape is not limited thereto. In addition, the length E_{d1} of the first extended portion 131a in the Z-axis direction may be a maximum value of the length of the first extended portion 131a in the Z-axis direction or a minimum value of the length of the first extended portion 131a in the Z-axis direction.

In addition, the first notch portion 131b may be provided between a central position of a total length of the first extended portion 131a in the X-axis direction and an end portion of the first extended portion 131a on the positive X-axis direction side (refer to FIG. 8A). Furthermore, when a starting point is the end portion of the first extended portion 131a on the positive X-axis direction side and an end point is a tip position of the first end portion 131c, the first notch portion 131b may be provided in at least a part of a range from 5% to 40% of the total length of the first extended portion 131a in the X-axis direction. By setting an upper limit on a range in which the first notch portion 131b is provided in this manner, displacement of the first terminal 131 from the predetermined position can be suppressed when the first terminal 131 is placed in the first mold 310. Furthermore, by setting a lower limit on the range in which the first notch portion 131b is provided, deformation of the first terminal 131 in the respective molding steps can be suppressed.

As shown in FIG. 8B, the second extended portion 132a has the second end portion 132c formed with a width (E_{d2}) being a length in the Z-axis direction that is narrower than widths of other portions. In FIG. 8B, when an area extending the width of the second end portion 132c in the positive X-axis direction (indicated by hatchings) is defined as a second area Eₐ₂, the second notch portion 132b does not overlap with the second area Eₐ₂. In other words, in a plan view along the Y-axis direction, the second area Eₐ₂ based on a length E_{d2} of the second end portion 132c along the Z-axis direction and the second notch portion 132b do not overlap with each other. For example, in a plan view along the Y-axis direction, the second area Eₐ₂ is an area defined by the length E_{d2} being a length of one side of the second area Eₐ₂, two line segments perpendicular along the X-axis direction to each of both ends of the one side with the length E_{d2}, and a side parallel to the length E_{d2}. Since the second extended portion 132a can achieve certain rigidity due to having this shape, deformation such as bending when the second end portion 132c is subjected to an external force in the positive X-axis direction can be suppressed. Note that a length of the second end portion 132c along the Z-axis direction may be longer than a length of the second notch portion 132b along the Z-axis direction. While an example in which the shape of the second area Eₐ₂ is a rectangular shape is described in the present example embodiment, the shape is not limited thereto. In addition, when the length of the second extended portion 132a in the Z-axis direction differs according to the position in the X-axis direction, the length E_{d2} of the second extended portion 132a in the Z-axis direction may be a maximum value of the length of the second extended portion 132a in the Z-axis direction or a minimum value of the length of the second extended portion 132a in the Z-axis direction.

In addition, the second notch portion 132b may be provided between a central position of a total length of the second extended portion 132a in the X-axis direction and an end portion of the second extended portion 132a on the positive X-axis direction side (refer to FIG. 8B). Furthermore, when a starting point is the end portion of the second extended portion 132a on the positive X-axis direction side and an end point is a tip position of the second end portion 132c, the second notch portion 132b may be provided in at least a part of a range from 15% to 50% of the total length of the second extended portion 132a in the X-axis direction. By setting an upper limit on a range in which the second notch portion 132b is provided in this manner, displacement of the second terminal 132 from the predetermined position can be suppressed when the second terminal 132 is placed in the first mold 310. Furthermore, by setting a lower limit on the range in which the second notch portion 132b is provided, deformation of the second terminal 132 in the respective molding steps can be suppressed.

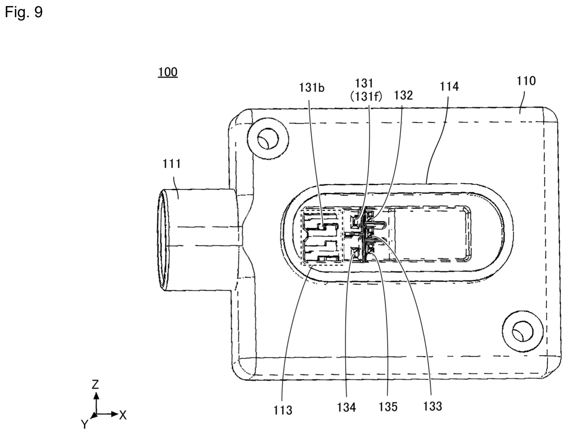

FIG. 9 is a bottom view of the wiring unit 100 after molding. As described earlier, one end of each terminal is exposed in the space enclosed by the insertion port 111 and the other end is exposed in the space enclosed by the substrate housing wall 114. FIG. 9 shows other ends (including the third end portion 131f of the first terminal 131 and the fourth end portion 132f of the second terminal 132) exposed in the space enclosed by the substrate housing wall 114.

Furthermore, as described above, the resin block 110 has the recessed portion 113 with an opening on the bottom surface side. The recessed portion 113 is the space formed when resin is not filled due to the protrusion 311 of the first mold 310, as described using FIGS. 5 and 6. Therefore, the space enclosed by the recessed portion 113 communicates with external space.

As described above, when observing the first notch portion 131b and the second notch portion 132b in a plan view along the Y-axis direction from the side of the first terminal 131, the first notch portion 131b encompasses the second notch portion 132b. Therefore, when viewed from the opening side of the recessed portion 113, although the second terminal 132 is located further back than the first terminal 131, a part of the second terminal 132 can be observed. In other words, the second notch portion 132b can be described as being exposed to external space toward the first notch portion 131b. Alternatively, the first notch portion 131b and the second notch portion 132b can be described as being exposed in at least one negative Y-axis direction (for example, the negative Y-axis direction in FIG. 9) in a state where the first notch portion 131b and the second notch portion 132b have been molded. In this manner, due to the recessed portion 113 having an opening, if a part of the second terminal 132 can be observed from the first notch portion 131b, it is possible to confirm whether the first terminal 131 and the second terminal 132 are arranged correctly without misalignment and the like in the wiring unit 100 after molding. The relationship between the first terminal 131 and the second terminal 132 described above similarly applies to the relationship between the fourth terminal 134 and the fifth terminal 135. Note that in a configuration in which the recessed portion 113 also has an opening on the top surface side and is partially penetrated, the first notch portion 131b and the second notch portion 132b may also be exposed to the space on the top surface side.

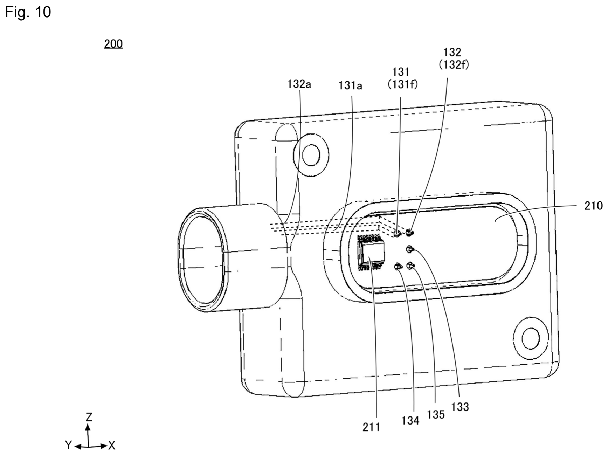

FIG. 10 is a perspective view of a magnetic sensor unit 200 in which the sensor substrate 210 is mounted to the wiring unit 100. Specifically, FIG. 10 illustrates an example in which the sensor substrate 210 is housed and fixed in the space enclosed by the substrate housing wall 114 of the wiring unit 100. The sensor substrate 210 is electrically connected to each of the first terminal 131 to the fifth terminal 135.

A magnetic sensor chip 211 is mounted on the sensor substrate 210. A position where the magnetic sensor chip 211 is mounted on the sensor substrate 210 may be where, in a plan view along the Y-axis direction, the magnetic sensor chip 211 overlaps with at least a part of the first extended portion 131a of the first terminal 131 and at least a part of the second extended portion 132a of the second terminal 132. When the magnetic sensor chip 211 is mounted at this position, it is expected that the effects of external magnetic noise reaching from the top surface side will be reduced by the first extended portion 131a and the second extended portion 132a. Note that at least a part of each extended portion of the third terminal 133 to the fifth terminal 135 that extend in the X-axis direction may also overlap with the magnetic sensor chip 211 in a plan view along the Y-axis direction.

The respective elements of the wiring unit 100 and the magnetic sensor unit 200 equipped with the wiring unit 100 according to the present example embodiment described above may be modified in various ways. For example, while a rectangle is adopted as the shape of the respective notch portions in the present example embodiment, the shape may be a trapezoid or other shapes. In addition, depending on the specifications and materials of each terminal, for example, each end portion need not be formed with a narrower width as compared to other portions. Furthermore, the contours of the respective extended portions may be the same with the exception of the shape of each notch portion to be locked to the first mold 310. In addition, while the third extended portion 131d and the fourth extended portion 132d of the first terminal 131 and the second terminal 132 have been described as L-shapes extending in the Y-axis direction in the present example embodiment, the third extended portion 131d and the fourth extended portion 132d may extend in a direction that differs from the X-axis direction and the Y-axis direction. Furthermore, while L-shaped terminals are adopted in all cases in the present example embodiment, linear terminals may also be adopted. In this case, for example, since the sensor substrate 210 will have end portions capable of being connected to other wirings at both ends of an extended portion that extends in the X-axis direction, the sensor substrate 210 is to be arranged parallel to the YZ-plane.

According to the present disclosure, a wiring unit in which at least two resin-molded terminals are precisely arrayed without coming into contact with each other, a sensor unit equipped with the wiring unit, and a method of manufacturing the wiring unit can be provided.

## Claims

1. A wiring unit in which a plurality of terminals including at least a first terminal (**131**) and a second terminal (**132**) are resin-molded, wherein
the first terminal (**131**) has a first extended portion (**131a**) extending in a first direction and being provided with a first notch portion (**131b**),
the second terminal (**132**) has a second extended portion (**132a**) extending in the first direction and being provided with a second notch portion (**132b**), and
at least a part of the first extended portion (**131a**) and at least a part of the second extended portion (**132a**) face each other while being spaced apart in a second direction perpendicular to the first direction, and when the first notch portion (**131b**) and the second notch portion (**132b**) are viewed in a plan view along the second direction from a side opposite to the side where at least a part of the first extended portion (**131a**) faces at least a part of the second extended portion (**132a**), the first notch portion (**131b**) encompasses the second notch portion (**132b**).

2. The wiring unit according to claim 1, wherein
the first terminal (**131**) has: a first end portion (**131c**) formed on one end side of the first extended portion (**131a**) and capable of being connected to other wiring in the first extended portion (**131a**); and a third extended portion (**131d**) extending in the second direction and connected to another end opposite to the one end where the first end portion (**131c**) is provided, and
the second terminal (**132**) has: a second end portion (**132c**) formed on one end side of the second extended portion (**132a**) and capable of being connected to other wiring in the second extended portion (**132a**); and a fourth extended portion (**132d**) extending in the second direction and connected to another end opposite to the one end where the second end portion (**132c**) is provided.

3. The wiring unit according to claim 1, wherein
the first terminal (**131**) has: a first end portion (**131c**) formed on one end side of the first extended portion (**131a**) and capable of being connected to other wiring in the first extended portion (**131a**); and a third extended portion (**131d**) extending in a fourth direction that differs from the first direction and connected to another end opposite to the one end where the first end portion (**131c**) is provided, and
the second terminal (**132**) has: a second end portion (**132c**) formed on one end side of the second extended portion (**132a**) and capable of being connected to other wiring in the second extended portion (**132a**); and a fourth extended portion (**132d**) extending in the fourth direction and connected to another end opposite to the one end where the second end portion (**132c**) is provided.

4. The wiring unit according to claim 1, wherein
the first notch portion (**131b**) is a concave shape formed in a third direction perpendicular to the first direction and the second direction, and
the second notch portion (**132b**) is a concave shape formed in the third direction.

5. The wiring unit according to claim 4, wherein
the first extended portion (**131a**) has, on the side of one end in the first direction, a first end portion (**131c**) capable of being connected to other wiring, and
in a plan view along the second direction, the first area based on a length of the first end portion (**131c**) along the third direction and the first notch portion (**131b**) do not overlap with each other.

6. The wiring unit according to claim 4, wherein
the second extended portion (**132a**) has, on the side of one end in the first direction, a second end portion (**132c**) capable of being connected to other wiring, and
in a plan view along the second direction, the second area based on a length of the second end portion (**132c**) along the third direction and the second notch portion (**132b**) do not overlap with each other.

7. The wiring unit according to claim 5, wherein a length of the first end portion (**131c**) along the third direction is longer than a length of the first notch portion (**131b**) along the third direction.

8. The wiring unit according to claim 6, wherein a length of the second end portion (132c) along the third direction is longer than a length of the second notch portion (132b) along the third direction.

9. The wiring unit according to claim 4, wherein in a state where the first notch portion (131b) and the second notch portion (132b) have been molded, the first notch portion and the second notch portion are exposed in at least one direction of the second direction.

10. The wiring unit according to claim 4, wherein a contour of the first extended portion (131a) and a contour of the second extended portion (132a) differ from each other in a plan view along the second direction.

11. The wiring unit according to claim 2, wherein
the third extended portion (**131d**) has: a third notch portion (**131e**) formed in a concave shape in a third direction perpendicular to the first direction and the second direction; and a third end portion (**131f**) capable of being connected to other wiring on another end side opposite to one end connected to the first extended portion (**131a**), and
the fourth extended portion (**132d**) has: a fourth notch portion (**132e**) formed in a concave shape in the third direction; and a fourth end portion (**132f**) capable of being connected to other wiring on another end side opposite to one end connected to the second extended portion (**132a**).

12. The wiring unit according to claim 2, wherein at least a part of the third extended portion (**131d**) and at least a part of the fourth extended portion (**132d**) are arranged so as to face each other while being spaced apart in the first direction, and a contour of the third extended portion and a contour of the fourth extended portion differ from each other in a plan view along the first direction.

13. The wiring unit according to claim 11, wherein at least a part of the third end portion (**131f**) and at least a part of the fourth end portion (**132f**) overlap with each other in a plan view along the first direction.

14. A magnetic sensor unit, comprising:
the wiring unit according to any one of claims 1 to 13; and
a sensor substrate (**210**) being connected to the first terminal (**131**) and the second terminal (**132**) and mounted with a magnetic sensor chip (**211**).

15. The magnetic sensor unit according to claim 14, wherein the magnetic sensor chip (**211**) overlaps with at least a part of the first extended portion (**131a**) and at least a part of the second extended portion (**132a**) in a plan view along the second direction.

16. A method of manufacturing a wiring unit in which a plurality of terminals including at least a first terminal (**131**) and a second terminal (**132**) are resin-molded, the method of manufacturing the wiring unit comprising the steps of:
locking a first notch portion (**131b**) provided in a first extended portion (**131a**) extending in a first direction in the first terminal to a first locking portion (**311b**) of a protrusion (**311**) provided in a first mold (**310**) and fixing the first notch portion to the first mold;
locking a second notch portion (132b) provided in a second extended portion (132a) extending in the first direction in the second terminal to a second locking portion (311c) provided on a side of an end portion of the protrusion relative to the first locking portion in the protrusion and fixing the second notch portion to the first mold such that at least a part of the first extended portion (131a) and at least a part of the second extended portion (132a) face each other while being spaced apart in a second direction perpendicular to the first direction; and
filling resin into an internal space formed by the first mold (310) and other molds including a second mold (320).
